# EUROPEAN PATENT APPLICATION

(11) **EP 2 060 347 A1**
(43) Date of publication of application: **20.05.2009**
(21) Application number: 08446508.7
(22) Date of filing: 11.09.2008
(51) Int. Cl.: B23B 27/04, C23C 16/56

(54) **Inserts for parting or grooving and method of making**

(30) Priority: 05.10.2007 SE 0702232
(71) Applicant: Sandvik Intellectual Property AB, 811 81 Sandviken (SE)
(72) Inventor: Jonsson, Anders, SE 803 11 Gävle (SE)
(74) Representative: Hägglöf, Henrik

(57) **Abstract**

The present invention relates to a coated cutting tool insert with elongated shape with a rake face and an opposite bottom surface with improved strength properties obtained by providing the inserts with a blasted bottom surface. The inserts are preferably used for parting and grooving operations.

## Description

The present invention relates to cutting tool inserts particularly for parting or grooving with improved properties and method of making the same.

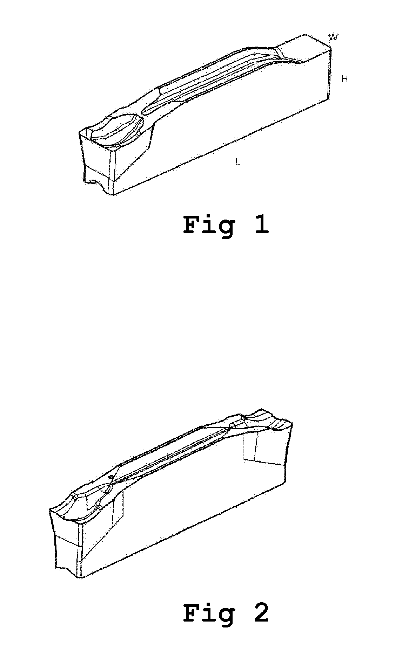

Inserts for parting and grooving have an elongated shape. They can have a cutting edge in only one end, Fig 1, or in both ends, Fig 2. They are single sided with a rake face with chip breakers to ensure effective chip removal particularly in parting operations where the space is often restricted. The bottom surface generally has a shape to ensure good stability of the insert in the holder. Generally, the bottom surface is slightly concave to ensure that the inserts essentially are in contact with the insert seat of the holder at its both ends.

Inserts for parting and grooving generally have a length of more than 15 mm and up to 35 mm, a width of 1-12 mm and a height of 5-10 mm. They are generally provided with coatings deposited by CVD, MTCVD or PVD as known in the art.

US 5,477,754 discloses a metal cutting insert made by sintering an insert body and coating the sintered insert body with a conventional coating. Subsequently, a supporting surface of the insert is ground smooth while removing the coating therefrom. The supporting surface of the insert is thereby formed by an uncoated, smoothly ground surface.

EP 1864731 A1 discloses an indexable insert wherein the residual stress in a coating on the rake face is lower than the residual stress in the bearing surface.

EP 1862240 A1 discloses an indexable insert wherein the coating on a seating face is removed completely or originally not formed thereon.

A problem with elongated inserts is that they sometimes fracture at an early stage or even already when fastened in the holder.

It is an object of the present invention to provide inserts particularly for parting and grooving with improved strength.

It is further object of the present invention to provide a method of making inserts particularly for parting and grooving with improved strength.

Fig 1 shows a parting and grooving insert with one cutting edge where
L - length,
H - heigth and
W - width.

Fig 2 shows a parting and grooving insert with two cutting edges.

According to the present invention, it has now surprisingly been found that if inserts particularly for parting and grooving are subjected to a blasting operation on the bottom surface a surprising increase in strength is obtained.

The present invention relates to a cutting tool insert with an elongated shape with a rake face and an opposite bottom surface, both with a coating, the insert has a length, L, width, W, and height, H, all in mm, such that L>W+H and the bottom surface of the insert is blasted. The cutting tool insert is particularly suitable for parting and grooving. The room temperature hardness of the cutting tool insert is suitably >1500 HV3. Preferably L>0.1*W*H*H. The length L is measured along the bottom surface, W and H in the middle of the insert. Both the rake face and the blasted bottom surface have a coating.

For a residual stress P in a coating, where P>0 represents a tensile residual stress and P<0 represents a compressive residual stress, the coating of the bottom surface has suitably a residual stress P(b) being less than the residual stress in the coating on the rake face P(r). Preferably, the residual stress in the coating of the bottom surface is compressive, i.e. P(b)<0.

The bottom side of the insert suitably has a concave shape so that the gap occurring between the bottom surface and a flat surface on which the inserts rests, measured at the middle of the insert, is > 0.01 mm, but < 0.1 mm, preferably < 0.05 mm.

The insert is preferably provided with a CVD and/or an MTCVD coating. The total thickness of the coating on non-blasted coated areas is suitably >4 µm, preferably >8 µm.

The rake face can be blasted for improved performance.

In one embodiment, the blasted bottom surface preferably has a remaining coating with a total thickness of preferably > 1 µm, most preferably > 3 µm.

The invention also relates to a method of making a cutting tool insert with a coating and having an elongated shape with a rake face and an opposite bottom surface, wherein the bottom surface is blasted and the insert has a length, L, width, W, and height, H, all in mm, such that L>W+H. Preferably L>0.1*W*H*H. The length L is measured along the bottom surface, W and H in the middle of the insert.

Preferably, the insert is provided with a CVD and/or an MTCVD coating. The total thickness of the coating on non-blasted coated areas is suitably >4 µm, preferably >8 µm.

According to the method the bottom surface of the inserts are after the coating subjected to a blasting operation, preferably wet blasting. In one embodiment, the rake face is also subjected to a blasting operation. Preferably, the blasting is made with a slurry comprising Al₂O₃ in water.

In one embodiment, the blasting operation is made with a slurry comprising F150 grits (FEPA-standard) of Al₂O₃ in water at an air pressure of 2.2-2.6 bar for about 10-20 sec/insert. The spray guns are placed about 100 mm from the inserts with a 90° spray angle.

The coating of the bottom surface preferably remains to a significant extent after the blasting operation, so that the total coating thickness after the blasting operation is preferably > 1 µm, most preferably > 3 µm.

The insert is particularly suitable for parting and grooving.

The invention also relates to use of the cutting tool insert according to the invention for parting and grooving operations.

### Example 1

Ten inserts of type N123H2-0400-0004 TF with a composition 6 wt-% Co and rest WC with an average grain size of about 2 µm and a hardness at room temperature of 1600 HV3 to be used for parting operations with a length of 25 mm, a width of 3 mm and a thickness of 6 mm were provided with a coating consisting of 5 µm MTCVD-Ti(C,N)+ 4 µm Al₂O₃. All ten inserts were blasted on the rake face. Five of them were further subjected to the same blasting operation on the bottom surface.

The wet blasting operation was performed with a slurry consisting of F150 grits (FEPA-standard) of Al₂O₃ in water at an air pressure of 2.4 bar for about 15 sec/insert. The spray guns were placed about 100 mm from the inserts with a 90° spray angle.

The inserts were then subjected to a conventional transverse rupture test. The distance between the supports was 20 mm. The force in N necessary to break the inserts was determined. The following results were obtained:

| Treatment | Force to fracture in N | | | | | Average, N |
|---|---|---|---|---|---|---|
| Blasted | 8681 | 10000 | 9630 | 9253 | 10230 | 9559 |
| Unblasted | 7721 | 7271 | 7711 | 7766 | 7055 | 7505 |

### Example 2

Example 1 was repeated with 10 inserts N123J2-0600-RO with a composition of 6 wt-% Co and rest WC with an average grain size of about 1 µm and a hardness at room temperature of 1750 HV3 with a length of 25 mm, a width of 4 mm and a thickness of 6 mm and a coating consisting of 2.5 µm MTCVD-Ti(C,N)+ 1.5 µm Al₂O₃ + 0.5 µm TiN.

The inserts were subjected to a conventional transverse rupture test. The distance between the supports was 17 mm. The force in N necessary to break the inserts was determined. The following results were obtained:

| Treatment | Force to fracture in N | | | | | Average, N |
|---|---|---|---|---|---|---|
| Blasted | 5232 | 4373 | 6452 | 6250 | 4284 | 5318 |
| Unblasted | 4946 | 3923 | 5835 | 5100 | 3480 | 4657 |

It is concluded that the present invention gives an increase in fracture strength.

## Claims

1. Cutting tool insert with a coating and an elongated shape with a rake face and an opposite bottom surface, wherein the insert has a length, L, width, W, and height, H, all in mm, such that L>W+H and that the bottom surface of the insert is blasted.

2. Cutting tool insert according to claim 1, wherein L>0.1*W*H*H.

3. Cutting tool insert according to claims 1 or 2, wherein the insert is provided with a CVD and/or MTCVD coating.

4. Cutting tool insert according to any one of claims 1-3, wherein the coating on non-blasted coated areas is >4 µm thick.

5. Cutting tool insert according to any one of claims 1-4, wherein the residual stress in the coating of the bottom surface is less than the residual stress in the coating on the rake face.

6. Cutting tool insert according to any one of claims 1-5, wherein the bottom side of the insert has a concave shape so that the gap occurring between the bottom surface and a flat surface on which the inserts rests, measured at the middle of the insert, is > 0.01 mm.

7. Cutting tool insert according to any one of claims 1-6, wherein the blasted bottom surface has a remaining coating with a total thickness of >3 µm.

8. Cutting tool insert according to any one of claims 1-7, wherein the insert is an insert for parting and grooving operations.

9. Cutting tool insert according to any one of claims 1-8, wherein the rake face is blasted.

10. Method of making a cutting tool insert having an elongated shape with a rake face and an opposite bottom surface, both with a coating, comprising providing a coated insert and blasting the bottom surface, the insert has a length, L, width, W, and height, H, all in mm, such that L>W+H.

11. Method according to claim 10, wherein L>0.1*W*H*H.

12. Method according to claims 10 or 11, wherein the insert is provided with a CVD and/or an MTCVD coating.

13. Method according to any one of claims 10-12, wherein the insert has a coating of a total thickness of >4 µm on non-blasted coated areas.

14. Method according to any one of claims 10-13, wherein the bottom side of the insert has a concave shape so that the gap occurring between the bottom surface and a flat surface on which the inserts rests, measured at the middle of the insert, is > 0.01 mm.

15. Method according to any one of claims 10-14, wherein the blasted bottom surface has a remaining coating with a total thickness of >3 µm.

16. Method according to any one of claims 10-15, wherein the rake face is subjected to a blasting operation.

17. Method according to any one of claims 10-16, wherein the insert is an insert for parting and grooving operations.

18. Use of a cutting tool insert according to any one of claims 1-9 for parting and grooving operations.
